# EUROPEAN PATENT APPLICATION

(11) **EP 3 971 959 A1**
(43) Date of publication of application: **23.03.2022**
(21) Application number: 21195543.0
(22) Date of filing: 08.09.2021
(51) Int. Cl.: H01L 23/495

(54) **PACKAGE STRUCTURE FOR LOW-CAPACITY TVS**

(30) Priority: 18.09.2020 CN 202010988921
(71) Applicant: Littelfuse Semiconductor (Wuxi) Co., Ltd., Wuxi, Jiangsu 214142 (CN)
(72) Inventor: Zhang, Lucas, Wuxi, 214142 (CN); Zhou, Jifeng, Wuxi, 214142 (CN); Cai, Charlie, Wuxi, 214142 (CN)
(74) Representative: Arnold & Siedsma

(57) **Abstract**

Provided herein are package structures for low-capacity transient-voltage-suppression (TVS) devices. In one example, a package structure may include a first lead frame including a die pad, and a chip stack coupled to the first lead frame. The chip stack may include a transient-voltage-suppression (TVS) device coupled to the die pad, a solder wafer coupled to the TVS device, and a glass passivation pallet (GPP) device coupled to the solder wafer.

## Description

### Field of the Disclosure

The disclosure relates generally to the field of semiconductor devices and, more particularly, to a package structure for low-capacity transient-voltage-suppression (TVS) devices.

### Background of the Disclosure

Packaging an integrated circuit is typically the final stage of semiconductor device fabrication. During packaging, a semiconductor die, which represents the core of a semiconductor device, is encased in a housing that protects the die against physical damage and corrosion. For example, semiconductor dies are commonly mounted on a copper substrate, using solder alloy reflow, conductive epoxy, and the like. The mounted semiconductor die is often then encapsulated within a plastic or epoxy compound.

As power requirements of semiconductor devices have increased, larger semiconductor dies, sometimes referred to as "large area semiconductor dies," have become necessary for providing correspondingly greater levels of current handling. In some cases, such as in TVS diode applications, multiple large area dies must be connected in series in a stacked configuration to provide a sufficiently high breakdown voltage. However, increasingly larger semiconductor dies used, e.g., for surface mounting c-type (SMC) packages, have too large of a solder-void ratio. It is with respect to at least this drawback that the present disclosure is provided.

### Summary

The Summary is provided to introduce a selection of concepts in a simplified form, the concepts further described below in the Detailed Description. The Summary is not intended to identify key features or essential features of the claimed subject matter, nor is the Summary intended as an aid in determining the scope of the claimed subject matter.

In some embodiments, a package structure may include a first lead frame including a die pad, and a chip stack coupled to the first lead frame. The chip stack may include a transient-voltage-suppression (TVS) device coupled to the die pad, a conductive wafer coupled to the TVS device, and a glass passivation pallet (GPP) device coupled to the conductive wafer.

In some embodiments, a semiconductor package may include a first lead frame including a die pad, and a chip stack coupled to the first lead frame, wherein the chip stack comprises a solder wafer sandwiched between a transient-voltage-suppression (TVS) chip and a glass passivation pallet (GPP) chip.

In some embodiments, a method for forming a package structure may include providing a first lead frame including a die pad, and coupling a chip stack to the first lead frame. The chip stack may include a transient-voltage-suppression (TVS) device coupled to the die pad, a solder wafer coupled to the TVS device, and a glass passivation pallet (GPP) device coupled to the solder wafer.

### Brief Description of the Drawings

The accompanying drawings illustrate exemplary approaches of the disclosure, including the practical application of the principles thereof, as follows:
FIG. 1 is a side view of a semiconductor package according to embodiments of the present disclosure;
FIG. 2 is a top view of a first lead frame of the semiconductor package according to embodiments of the present disclosure;
**FIG. 3** is a side view of the first lead frame of the semiconductor package according to embodiments of the present disclosure;
**FIG. 4** is top view of a clip of the semiconductor package according to embodiments of the present disclosure;
**FIG. 5** is a side view of the clip of the semiconductor package according to embodiments of the present disclosure;
**FIG. 6** is a top view of a glass passivation process (**GPP**) chip of the semiconductor package according to embodiments of the present disclosure;
**FIG. 7** is a side view of the **GPP** chip of the semiconductor package according to embodiments of the present disclosure;
**FIG. 8** is a flow chart of a method according to embodiments of the present disclosure.

The drawings are not necessarily to scale. The drawings are merely representations, not intended to portray specific parameters of the disclosure. The drawings are intended to depict typical embodiments of the disclosure, and therefore should not be considered as limiting in scope. In the drawings, like numbering represents like elements.

Furthermore, certain elements in some of the figures may be omitted, or illustrated not-to-scale, for illustrative clarity. Cross-sectional views may be in the form of "slices", or "near-sighted" cross-sectional views, omitting certain background lines otherwise visible in a "true" cross-sectional view, for illustrative clarity. Furthermore, for clarity, some reference numbers may be omitted in certain drawings.

### Detailed Description

Devices, packages, and methods in accordance with the present disclosure will now be described more fully hereinafter with reference to the accompanying drawings, in which embodiments of the system and method are shown. The devices, packages, and methods, however, may be embodied in many different forms and should not be construed as being limited to the embodiments set forth herein. Rather, these embodiments are provided so that this disclosure will be thorough and complete, and will fully convey the scope of the devices, packages, and methods to those skilled in the art.

One recent development direction for power semiconductor discrete packaging is faster recovery capability. To improve this capability, embodiments of the present disclosure are directed to low-capacity and high-power TVS SMC products manufactured in the line. More specifically, package structures of the present disclosure reduce the chip electrical capacity values by using a glass passivation process (GPP) chip. GPP chips have lower capacity values and high reliability features. To avoid the solder-void ratio issue inherent in larger SMC packages, embodiments of the present disclosure include a stack structure in which a first chip is the GPP chip, and a second chip is a planar transient-voltage-suppression (TVS) chip. A third chip may be a solder wafer sandwiched between the first and second chips. By replacing a solder paste with a solder wafer, a void area of the stack can be eliminated.

In some embodiments, the package structure may include a lead frame including a grooved pad, which increases solder retainment. Furthermore, the package structure may include an improved clip for increased thermal dissipation and faster recovery capacity.

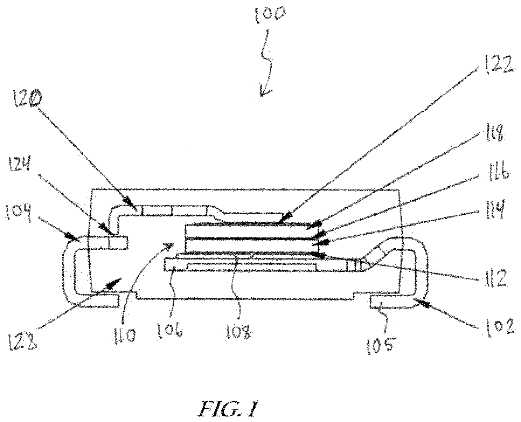

Referring to **FIG. 1**, an exemplary embodiment of a semiconductor device or package structure 100 in accordance with the present disclosure is shown. The exemplary package structure (hereinafter "structure") 100 may include a first lead frame 102 and a second lead frame 104. The first lead frame 102 may include a first end 105 and a second end 106. Although not shown, the first end 105 may be coupled to a substrate, PCB, etc. The second end 106 may include a die pad 108, which is coupled to a chip stack 110 by a solder 112. In other embodiments, the die pad 108 is attached to the chip stack 110 using a conductive epoxy or another suitable material. Although non-limiting, the first and second lead frames 102, 104 may be made of a conductive material (e.g., copper, copper alloy, silver, or the like) and configured to provide electrical connection between the die pad 108 and a circuit to which the structure 100 is to be connected.

In some embodiments, the chip stack 110 may include a TVS device/chip 114 coupled to the die pad 108, a conductive wafer 116 coupled to the TVS device 114, and a glass passivation pallet (GPP) device 118 coupled to the conductive wafer 116. In some embodiments, the conductive wafer 116 is a solder wafer. As shown, the GPP device 188 may be coupled to a clip 120 by a solder 122. The clip 120 may be coupled to the second lead frame 104 by a solder 124. In some embodiments, the clip 120 is a conductive material (e.g., copper, copper alloy, silver, or the like), which provides a direct electrical path between the substrate, the die pad 108, and the first and second lead frames 102, 104. As further shown, the structure 100 may include an encapsulation 128 (e.g., epoxy compound) surrounding the chip stack 110 and the clip 120. In some embodiments, the first lead frame 102 and the second lead frame 104 may extend outside the encapsulation 128.

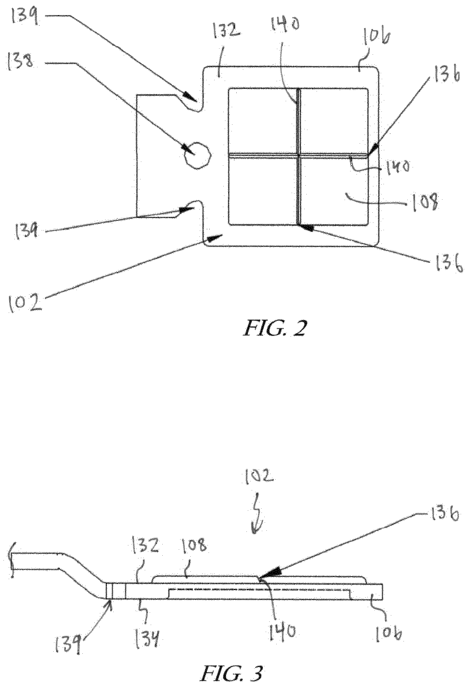

Turning now to **FIGs. 2-3**, the first lead frame 102 according to embodiments of the present disclosure will be described in greater detail. As shown, the second end 106 of the first lead frame 102, which includes a first side 132 opposite a second side 134, may be generally planar. Coupled to the first side 132 is the die pad 108. In some embodiments, the die pad 108 may include one or more recessed channels 136. As shown, the recessed channels 136 each include a set of walls 140 defining a u-shaped or v-shaped cross-sectional profile. The recessed channels 136 allow the solder 112 to enter, thus improving adhesive of the chip stack 110 and the die pad 108 during thermal cycles. Furthermore, the recessed channels 136 reduce accumulation of stress during thermal cycles. Although two recessed channels 136 are shown in a windowpane configuration, it will be appreciated that the number and configuration of the recessed channels 136 is non-limiting. As further shown, the first lead frame 102 may include a locking hole 138 and a set of corner notches 139, which provide flexibility to the first lead frame 102.

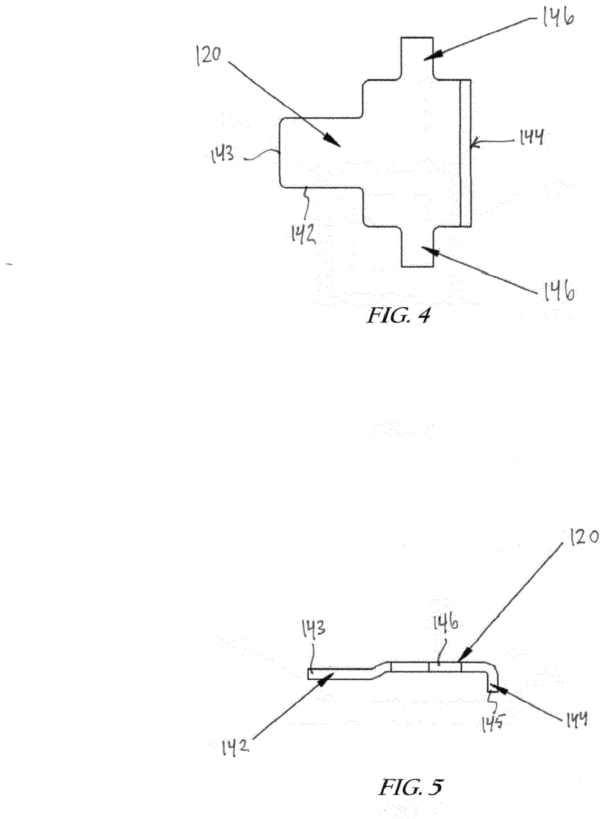

Turning now to **FIGs. 4-5**, the clip 120 according to embodiments of the present disclosure will be described in greater detail. As shown, the clip 120 may include a first contact area 142 at a first end 143 and a second contact area 144 at a second end 145. In some embodiments, the first contact area 142 is generally planar for increased contact with the GPP device 118. The second contact area 144 may generally extend perpendicular to the first contact area 142. The second contact area 144 may be electrically connected to the second lead frame 104. As further shown, the clip 120 may further include a set of clip gates 146 on opposite sides.

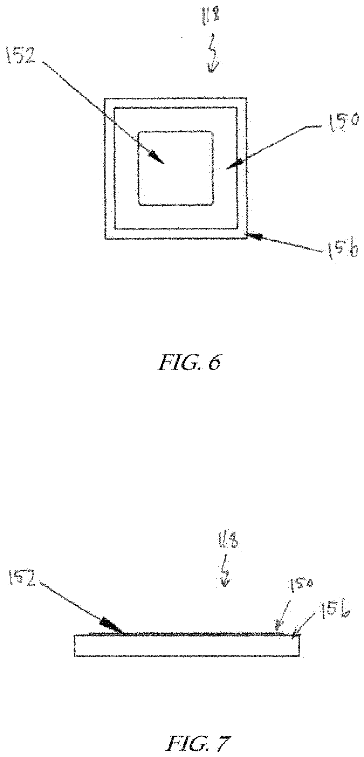

Turning now to **FIGs. 6-7**, the GPP device 118 according to embodiments of the present disclosure will be described in greater detail. As shown, the GPP device 118 may include a passivation layer 150, which may be a chip glass area, and a mesa area 152. Surrounding the mesa area 152 is a dicing area 156. In exemplary embodiments, the passivation layer 150 may be electrically connected to the clip 120 by solder 122 (not shown).

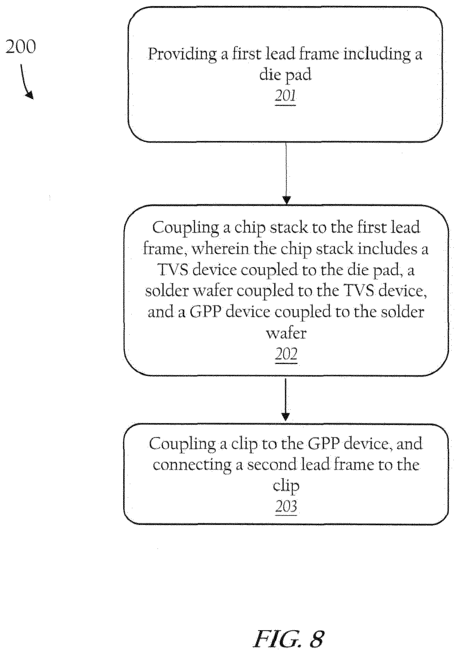

Turning now to **FIG. 8**, a method 200 for forming a package structure according to embodiments of the present disclosure will be described. At block 201, the method 200 may include providing a first lead frame including a die pad. At block 202, the method 200 may include coupling a chip stack to the first lead frame, wherein the chip stack includes a TVS device coupled to the die pad, a solder wafer coupled to the TVS device, and a GPP device coupled to the solder wafer.

In some embodiments, at block 203, the method 200 may optionally include coupling a clip to the GPP device, and connecting a second lead frame to the clip. In some embodiments, the method may include providing an encapsulation (e.g., an epoxy) around the chip stack and the clip, wherein the first lead frame and the second lead frame extend outside the encapsulation. In some embodiments, the method may include providing a first solder between the TVS device and the die pad, wherein the first solder extends within a recessed channel of the die pad. In some embodiments, the method may include connecting a first contact area of the clip to the GPP device by a second solder and connecting a second contact area of the clip to the second lead frame by a third solder.

Although the illustrative method 100 is described above as a series of acts or events, the present disclosure is not limited by the illustrated ordering of such acts or events unless specifically stated. For example, some acts may occur in different orders and/or concurrently with other acts or events apart from those illustrated and/or described herein, in accordance with the disclosure. In addition, not all illustrated acts or events may be necessary to implement a methodology in accordance with the present disclosure. Furthermore, the method 100 may be implemented in association with the formation and/or processing of structures illustrated and described herein as well as in association with other structures not illustrated.

As used herein, an element or step recited in the singular and proceeded with the word "a" or "an" is understood as not excluding plural elements or steps, unless such exclusion is explicitly recited. Furthermore, references to "one embodiment" of the present disclosure are not intended to be interpreted as excluding the existence of additional embodiments also incorporating the recited features.

The use of "including," "comprising," or "having" and variations thereof herein is meant to encompass the items listed thereafter and equivalents thereof as well as additional items. Accordingly, the terms "including," "comprising," or "having" and variations thereof are open-ended expressions and can be used interchangeably herein.

The phrases "at least one", "one or more", and "and/or", as used herein, are open-ended expressions and are both conjunctive and disjunctive in operation. For example, expressions "at least one of A, B and C", "at least one of A, B, or C", "one or more of A, B, and C", "one or more of A, B, or C" and "A, B, and/or C" means A alone, B alone, C alone, A and B together, A and C together, B and C together, or A, B and C together.

All directional references (e.g., proximal, distal, upper, lower, upward, downward, left, right, lateral, longitudinal, front, back, top, bottom, above, below, vertical, horizontal, radial, axial, clockwise, and counterclockwise) are just used for identification purposes to aid the reader's understanding of the present disclosure. The directional references do not create limitations, particularly as to the position, orientation, or use of the disclosure. Connection references (e.g., attached, coupled, connected, and joined) are to be construed broadly and may include intermediate members between a collection of elements and relative movement between elements unless otherwise indicated. As such, connection references do not necessarily infer two elements are directly connected and in fixed relation to each other.

Furthermore, identification references (e.g., primary, secondary, first, second, third, fourth, etc.) are not intended to connote importance or priority, and are used to distinguish one feature from another. The drawings are for purposes of illustration, and the dimensions, positions, order and relative sizes reflected in the drawings attached hereto may vary.

Furthermore, the terms "substantial" or "approximately," as well as the terms "approximate" or "approximately," can be used interchangeably in some embodiments, and can be described using any relative measures acceptable by one of ordinary skill in the art. For example, these terms can serve as a comparison to a reference parameter, to indicate a deviation capable of providing the intended function. Although non-limiting, the deviation from the reference parameter can be, for example, in an amount of less than 1%, less than 3%, less than 5%, less than 10%, less than 15%, less than 20%, and so on.

The foregoing description of example embodiments has been presented for the purposes of illustration and description. It is not intended to be exhaustive or to limit the present disclosure to the precise forms disclosed. Many modifications and variations are possible in light of this disclosure. It is intended that the scope of the present disclosure be limited not by this detailed description, but rather by the claims appended hereto. Future filed applications claiming priority to this application may claim the disclosed subject matter in a different manner, and may generally include any set of one or more limitations as variously disclosed or otherwise demonstrated herein.

## Claims

1. A package structure, comprising:
a first lead frame including a die pad; and
a chip stack coupled to the first lead frame, wherein the chip stack comprises:
a transient-voltage-suppression (TVS) device coupled to the die pad;
a conductive wafer coupled to the TVS device; and
a glass passivation pallet (GPP) device coupled to the conductive wafer.

2. The package structure of claim 1, further comprising:
a clip coupled to the GPP device; and
a second lead frame connected to the clip, preferably further comprising an encapsulation surrounding the chip stack and the clip, wherein the first lead frame and the second lead frame extend outside the encapsulation.

3. The package structure of claims 1 or 2, further comprising a first solder between the TVS device and the die pad.

4. The package structure of claim 3, wherein the die pad includes a recessed channel, and wherein the first solder extends within the recessed channel.

5. The package structure of claim 4, wherein the recessed channel includes a set of walls defining a u-shaped profile or a v-shaped profile.

6. The package structure of any of the claims 3-5, wherein the clip comprises a first contact area and a second contact area, wherein the first contact area is connected to the GPP device by a second solder, and wherein the second contact area is connected to the second lead frame by a third solder.

7. The package structure of any of the preceding claims, wherein the conductive wafer is sandwiched between the TVS device and the GPP device.

8. A semiconductor package, comprising:
a first lead frame including a die pad; and
a chip stack coupled to the first lead frame, wherein the chip stack comprises a solder wafer sandwiched between a transient-voltage-suppression (TVS) chip and a glass passivation pallet (GPP) chip.

9. The semiconductor package of claim 8, wherein the TVS chip is coupled to the die pad by a first solder.

10. The semiconductor package of claim 8 or 9, further comprising:
a clip coupled to the GPP chip; and
a second lead frame connected to the clip.

11. The semiconductor package of claim 10, with one or more of the following:
further comprising an encapsulation surrounding the chip stack and the clip, wherein the first lead frame and the second lead frame extend outside the encapsulation;
wherein the die pad includes a recessed channel, wherein the first solder extends within the recessed channel, and wherein the recessed channel includes a set of walls defining a u-shaped profile or a v-shaped profile;
wherein the clip comprises a first contact area and a second contact area, wherein the first contact area is connected to the GPP chip by a second solder, and wherein the second contact area is connected to the second lead frame by a third solder.

12. A method for forming a package structure, comprising:
providing a first lead frame including a die pad; and
coupling a chip stack to the first lead frame, wherein the chip stack comprises:
a transient-voltage-suppression (TVS) device coupled to the die pad;
a solder wafer coupled to the TVS device; and
a glass passivation pallet (GPP) device coupled to the solder wafer.

13. The method of claim 12, further comprising:
coupling a clip to the GPP device; and
connecting a second lead frame to the clip.

14. The method of claim 13, further comprising providing an encapsulation around the chip stack and the clip, wherein the first lead frame and the second lead frame extend outside the encapsulation.

15. The method of claim 13 or 14, further comprising providing a first solder between the TVS device and the die pad, wherein the first solder extends within a recessed channel of the die pad,
and/or
further comprising connecting a first contact area of the clip to the GPP device by a second solder and connecting a second contact area of the clip to the second lead frame by a third solder.
